# EUROPEAN PATENT APPLICATION

(11) **EP 4 040 925 A1**
(43) Date of publication of application: **10.08.2022**
(21) Application number: 22154649.2
(22) Date of filing: 01.02.2022
(51) Int. Cl.: H05K 3/34, H05K 1/02, H05K 1/11

(54) **CIRCUIT BOARD**

(30) Priority: 08.02.2021 JP 2021017981
(71) Applicant: AISIN CORPORATION, Aichi 448-8650 (JP)
(72) Inventor: HAYASHI, Kohei, KARIYA, AICHI, 448-8650 (JP); TAKEMOTO, Shuichi, KARIYA, AICHI, 448-8650 (JP); KONDO, Yuji, KARIYA, AICHI, 448-8650 (JP); SUZUKI, Takaya, KARIYA, AICHI, 448-8650 (JP)
(74) Representative: Cabinet Beau de Loménie

(57) **Abstract**

A circuit board (10) being able to easily ensure flatness of solder (40) placed on a substrate (11) for bonding an electronic component (50) and improve bonding reliability of the electronic component (50) by the solder (40), includes: a substrate (11) having a plurality of layers made of a conductive material; a land (13) provided on a first layer arranged on one side (11A) of the substrate (11), to which the electronic component (50) is soldered; a heat sink (18) provided on a different layer arranged on the substrate; a via hole (14) provided on the substrate (11) from a part of the land (13) over to a part of the heat sink (18) and electrically connected to the land (13) and the heat sink (18); and an insulating resist (15) disposed on the land (13) and surrounding the entire circumference of the via hole (14).

## Description

### TECHNICAL FIELD

This disclosure generally relates to a circuit board.

### BACKGROUND DISCUSSION

In a circuit board, soldering is used as a method of bonding electronic components to a substrate. Since some electronic components that are bonded to a substrate have a large number of electrodes, it is not easy to bond the electronic components to the substrate in a flat state. JP2011-258749A (Reference 1) discloses a configuration in which an electronic component ("a bottom electrode component" in the document) is soldered to a substrate ("a printed wiring board" in the document) by flow soldering. In the technique described in Reference 1, molten solder is supplied from a lower surface of the substrate to a through-hole and filled into the entire through-hole until the molten solder is ejected to a position higher than an upper surface of the substrate, which enables high-quality and highly reliable solder bonding regardless of influence of flatness of the electronic components and the substrate.

In addition to the soldering using flow solder described in Reference 1 (hereinafter, referred to as "flow soldering"), there is another technique of soldering for fixing electronic components to a substrate by using reflow solder (hereinafter, referred to as "reflow soldering"). In the reflow soldering, cream solder (hereinafter, referred to as "solder") is printed on a land of a substrate, electronic components are placed on the cream solder, and the entire substrate is heated, thus the electronic components are bonded to the substrate through the molten solder.

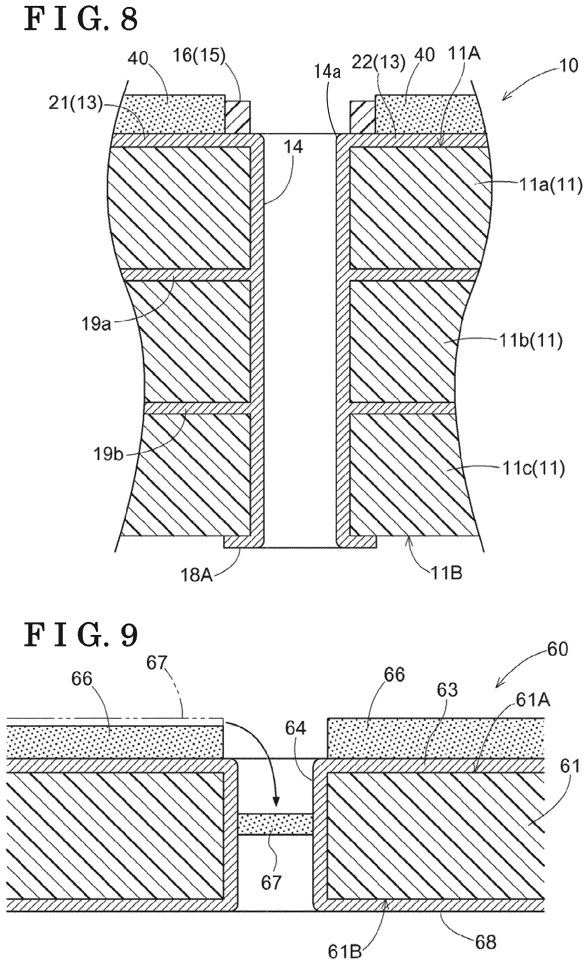

Unlike flow soldering, in a case of reflow soldering, an amount of solder is determined depending on solder printed on a substrate, and the amount of solder cannot be increased after that. Fig. 9 illustrates a conventional circuit board 60 in which a land 63 is provided on one side 61A of a substrate 61, a heat dissipation pattern 68 is provided on the other side 61B, and a through-hole via 64, which is an example of a via hole, is formed between the land 63 and the heat dissipation pattern 68. Both the land 63 and the heat dissipation pattern 68 are plated copper foils attached to the substrate 61. The through-hole via 64 is, for example, made by copper-plating an inner surface of a hole penetrating the substrate 61, and the land 63 and the heat dissipation pattern 68 are electrically connected through the copper plating. In the circuit board 60 illustrated in Fig. 9, cream solder 66 (hereinafter, referred to as "solder 66") is printed on the land 63 at a position close to the through-hole via 64. In such a case, when the substrate 61 is heated and the solder 66 melts, a part 67 of the solder 66 may flow into the through-hole via 64. Then, an amount of solder is reduced in the part of the solder 66 printed on the land 63, which impairs the overall flatness of the solder 66. As a result, flatness of an electronic component mounted on the solder 66 is also impaired, thus bonding reliability between the electronic component and the land 63 by the solder 66 is lowered. Specifically, when the electronic component is bonded to the substrate 61 in an inclined state through the solder 66, the bonding reliability by the solder 66 cannot be ensured. Further, when thickness of the solder 66 is reduced in a partial area, cracks may occur in the solder 66 when the solder 66 having small thickness is stressed by the substrate 61 due to deformation of the substrate by heating or the like. In such a case, the bonding reliability of the electronic component by the solder 66 is further lowered.

A need thus exists for a circuit board that is able to easily ensure flatness of solder being mounted on a substrate for bonding an electronic component and improve bonding reliability of the electronic component by the solder.

### SUMMARY

A configuration of a circuit board according to this disclosure includes a substrate, a land, a heat sink, a via hole, and an insulating resist. The substrate has a plurality of layers made of a conductive material. The land is provided on a first layer that is one of the layers and is arranged on a surface of one side of the substrate, and an electronic component is soldered to the land. The heat sink is provided on another one of the layers that is arranged on the substrate and is different from the first layer. The via hole is provided on the substrate from a part of the land over to a part of the heat sink and electrically connected to the land and the heat sink and includes an opening formed on the land. The insulating resist is arranged on the land and surrounds the entire circumference of the opening of the via hole.

In reflow soldering, cream solder (hereinafter, also referred to as "solder") is used as solder for bonding an electronic component to a substrate. According to this configuration, the insulating resist is placed on the land and surrounds the entire circumference of the opening of the via hole. Thus, the resist prevents solder on the land from flowing into the via hole when an electronic component is bonded to the substrate by reflow soldering. This can maintain the solder on the land of the substrate at an initial amount being printed, and thus ensure flatness of the solder printed on the substrate for bonding an electronic component. As a result, an inclination of the electronic component bonded to the substrate through the solder with respect to the substrate can be suppressed, thereby improving bonding reliability of the electronic component by the solder on the circuit board. In this way, heat generated by the electronic component mounted on the first layer can be efficiently transferred and dissipated through the land and the via hole to the heat sink provided on the layer that is arranged on the substrate and is different from the first layer. Further, by maintaining the amount of solder printed on the land, it is possible to sufficiently secure thickness of the solder for bonding the electronic component to the land. This can suppress occurrence of cracks in the solder even when the solder receives stress from the substrate due to deformation of the substrate by heating or the like.

Another configuration is that the land may include a plurality of compartment lands partitioned by the resist.

According to this configuration, since the land includes a plurality of compartment lands partitioned by the resist, an electronic component can be soldered to the substrate by distributing and printing an appropriate amount of solder in each of the plurality of compartment lands. Since solder is printed over a plurality of compartment lands, a wide solder area can be secured for the electronic component while an area of each solder to be printed is reduced. This allows heat generated by the electronic component to be efficiently transferred to the land. Further, since solder printed on the plurality of compartment lands is partitioned by the resist, the solder stays in the compartment lands and does not flow into the via hole. Therefore, the solder printed on the plurality of compartment lands can ensure flatness of the solder to be used when the electronic component is bonded to the substrate and can improve bonding reliability of the electronic component by the solder on the circuit board, while heat generated by the electronic component can be efficiently dissipated from the heat sink.

Another configuration is that each of the plurality of compartment lands may share at least a partial outer edge with the entire outer edge of the land.

Solder often contains flux, and the flux volatilizes into flux gas when the solder melts. In a case where the flux gas is not discharged to an outside of the solder, the flux gas remains inside the solder as a void. The remaining void in the solder deteriorates bondability between the electronic component and the land, which results in heat generated by the electronic component not being efficiently transferred from the solder to the land. Thus, in this configuration, each of the plurality of compartment lands shares at least a partial outer edge with the entire outer edge of the land. In this way, in the compartment lands partitioned by the resist, the outer edges shared with the outer edge of the land are open outward, and thus flux gas in the solder can be discharged to an outside from the outer edges of the compartment lands. As a result, generation of voids in the solder can be reduced, which can ensure properly maintaining bondability of the electronic component by the solder printed on the compartment lands and transfer of heat generated by the electronic component to the land.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a partial plan view of a circuit board according to a first embodiment and illustrates a state in which an electronic component is mounted on a land;
Fig. 2 is a partial plan view of the land on the circuit board according to the first embodiment;
Fig. 3 is a cross-section view taken along the line III-III of Fig. 1;
Fig. 4 is a graph illustrating an inclination of an electronic component and an average crack rate of solder in an embodiment and in a comparative example;
Fig. 5 is a partial plan view of lands on a circuit board according to a second embodiment;
Fig. 6 is a partial cross-section view of a circuit board according to another embodiment;
Fig. 7 is a partial cross-section view of a circuit board according to another embodiment;
Fig. 8 is a partial cross-section view of a circuit board according to another embodiment; and
Fig. 9 is a partial cross-section view of a conventional circuit board.

### DETAILED DESCRIPTION

The following describes embodiments of a circuit board according to this disclosure with reference to the drawings. Provided that this disclosure is not limited to the following embodiments, and various modifications can be made without departing from the principle thereof.

### [First Embodiment]

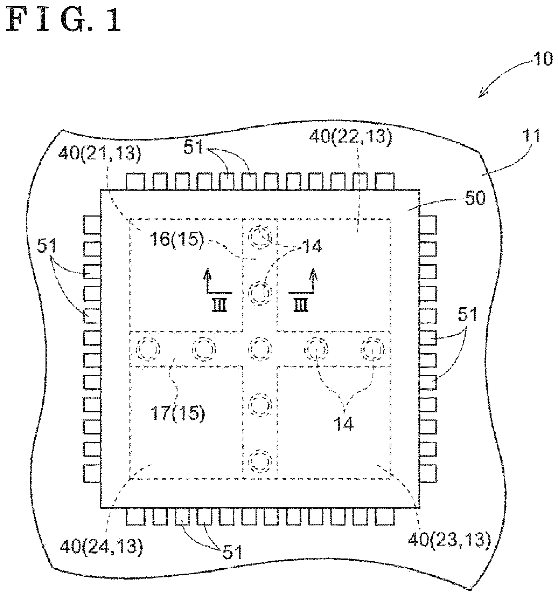

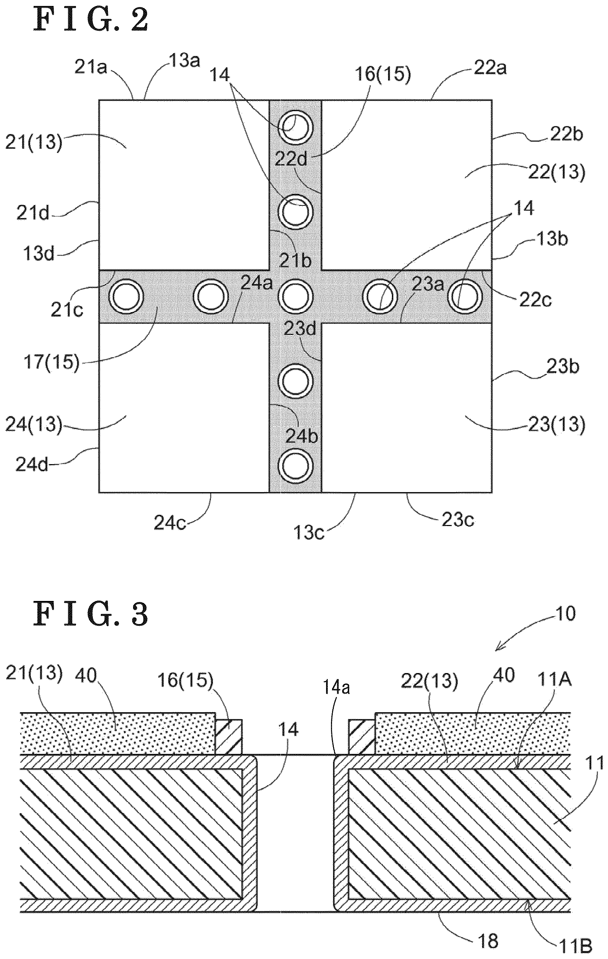

As illustrated in Figs. 1 to 3, a circuit board 10 includes a resin substrate 11, a land 13, via holes 14, and a heat dissipation pattern 18 (an example of a heat sink). The circuit board 10 according to this embodiment is a two-layer board (a double-sided board) in which a copper foil pattern, which is an example of a conductive material, is provided on both sides of the substrate 11. As illustrated in Fig. 3, the land 13 is provided on a first layer arranged on one side 11A of the substrate 11, to which an electronic component 50 (refer to Fig. 1) is soldered by cream solder 40 (hereinafter, also referred to as "solder 40"), and the heat dissipation pattern 18 for radiating heat generated by the electronic component 50 is provided on a layer arranged on the other side 11B of the substrate 11. In other words, the heat dissipation pattern 18 is provided on a layer that is arranged on the substrate 11 and is different from the first layer. The via hole 14 according to this embodiment is a through-hole via, which is formed in a thickness direction of the substrate 11 and is, for example, copper-plated on an inner surface of the hole penetrating the substrate 11, and the copper plating is provided from a part of the land 13 over to a part of the heat dissipation pattern 18. In addition, the via hole 14 has an opening 14a on the land 13. The land 13 and the heat dissipation pattern 18 are formed of, for example, plated copper foil or the like, and the land 13 and the heat dissipation pattern 18 are electrically connected through the copper plating applied to the inner surface of the via hole 14. The electronic component 50 is bonded to the land 13 of the substrate 11 by reflow soldering. Fig. 1 illustrates the circuit board 10 in which the electronic component 50 is bonded to the land 13 of the substrate 11 through the solder 40 (see Fig. 3). In this embodiment, the electronic component 50 has a plurality of terminals 51 on the outer edge portion and has a square shape in a plan view. In addition to the land 13, terminal lands (not illustrated) to which the terminals 51 are bonded are separately provided on the substrate 11.

The electronic component 50 to be bonded to the substrate 11 is, for example, a transistor, an IC, or the like, and is provided with a metal heat dissipation pad on the bottom surface. In this embodiment, as illustrated in Figs. 1 and 2, the land 13 is formed in a square shape similar to the plan view shape of the electronic component 50. As illustrated in Fig. 3, the solder 40 is printed on the land 13. In reflow soldering, the electronic component 50 is placed on the solder 40 and the entire substrate 11 is heated, and then the heat dissipation pad and the terminals 51 of the electronic component 50 are electrically bonded to the land 13 and the terminal lands through the molten solder 40.

As illustrated in Fig. 2, the square-shaped land 13 has outer edges 13a to 13d. The outer edges 13a to 13d are equivalent to four sides of the square-shaped land 13. A plurality of via holes 14 are provided along a straight line connecting the center of the outer edge 13a and the center of the outer edge 13c and a straight line connecting the center of the outer edge 13b and the middle of the outer edge 13d in such a way that the land 13 is evenly divided into four. In this embodiment, in the land 13 illustrated in Figs. 1 and 2, there are five via holes 14 being formed each in a vertical direction (between the outer edge 13a and the outer edge 13c) and in a horizontal direction (between the outer edge 13b and the outer edge 13d) where the central via hole 14 is shared. As illustrated in Figs. 1 to 3, an insulating resist 15 is provided on an upper surface of the land 13. The resist 15 is for protecting the wiring pattern provided on the substrate 11 and is formed of, for example, an epoxy resin or the like. In this embodiment, as illustrated in Figs. 1 and 2, the resist 15 has a linear vertical portion 16 extending from the center of the outer edge 13a of the land 13 to the center of the outer edge 13c and a linear horizontal portion 17 extending from the center portion of the outer edge 13b of the land 13 to the center portion of the outer edge 13d, which are formed in a cross shape on the land 13. Further, the resist 15 is provided, in the vertical portion 16 and the horizontal portion 17, so as to surround (cover) the entire circumference of the openings 14a of all the via holes 14. As a result, the land 13 to which the electronic component 50 is soldered is partitioned by the vertical portion 16 and the horizontal portion 17 of the resist 15 and divided into four compartment lands 21, 22, 23, and 24 that are square-shaped and have the same areas. Hereinafter, the compartment lands 21, 22, 23, and 24 are collectively referred to as the "land 13" or the "compartment lands 21 to 24."

In this way, since the resist 15 is on the land 13 and surrounds the entire circumference of the openings 14a of all the via holes 14, the resist 15 prevents the solder 40 printed on the land 13 from flowing into the via holes 14 when the electronic component 50 is bonded to the substrate 11 by reflow soldering. This can maintain the solder 40 on the land 13 of the substrate 11 at the initial amount being printed, and ensure flatness of the solder 40 printed on the substrate 11 for bonding the electronic component 50. As a result, an inclination of the electronic component 50 bonded to the substrate 11 through the solder 40 with respect to the substrate 11 can be suppressed, thereby bonding reliability of the electronic component 50 by the solder 40 can be improved on the circuit board 10. In this way, heat generated by the electronic component 50 can be efficiently transferred and dissipated through the land 13 and the via holes 14 to the heat dissipation pattern 18 provided on a layer that is arranged on the substrate 11 and is different from the first layer (the land 13). Further, by maintaining the amount of the solder 40 printed on the land 13, it is possible to sufficiently secure thickness of the solder 40 for bonding the electronic component 50 to the land 13. This can suppress occurrence of cracks in the solder 40 even when the solder 40 receives stress from the substrate 11 due to deformation of the substrate 11 by heating or the like.

Each of the compartment lands 21 to 24 shares at least partial outer edges with the outer edges 13a to 13d of the land 13. Specifically, the compartment land 21 located on the upper left of the land 13 in Fig. 2 has outer edges 21a to 21d equivalent to the four sides. Among the outer edges 21a to 21d, the outer edge 21a is shared with the outer edge 13a of the land 13, and the outer edge 21d is shared with the outer edge 13d of the land 13. The compartment land 22 located on the upper right of the land 13 in Fig. 2 has outer edges 22a to 22d equivalent to the four sides. Among the outer edges 22a to 22d, the outer edge 22a is shared with the outer edge 13a of the land 13, and the outer edge 22b is shared with the outer edge 13b of the land 13. The compartment land 23 located on the lower right of the land 13 in Fig. 2 has outer edges 23a to 23d equivalent to the four sides. Among the outer edges 23a to 23d, the outer edge 23b is shared with the outer edge 13b of the land 13, and the outer edge 23c is shared with the outer edge 13c of the land 13. The compartment land 24 located on the lower left of the land 13 in Fig. 2 has outer edges 24a to 24d equivalent to the four sides. Among the outer edges 24a to 24d, the outer edge 24c is shared with the outer edge 13c of the land 13, and the outer edge 24d is shared with the outer edge 13d of the land 13.

In this embodiment, since the land 13 is constituted of the compartment lands 21 to 24 partitioned by the resist 15 (16 and 17), the electronic component 50 can be soldered to the substrate 11 by distributing and printing an appropriate amount of the solder 40 on each of the plurality of compartment lands 21 to 24. Since the solder 40 is printed over the plurality of compartment lands 21 to 24, a wide area of the solder 40 can be secured for the electronic component 50 while an area of each solder 40 to be printed is reduced. This allows heat generated by the electronic component 50 to be efficiently transferred to the land 13. Further, the solder 40 printed on the compartment lands 21 to 24 tends to stay in the compartment lands 21 to 24 since the solder 40 is partitioned by the resist 15. Therefore, the solder 40 printed on the plurality of compartment lands 21 to 24 can ensure flatness of the solder 40 being used when the electronic component 50 is bonded to the substrate 11 and can improve bonding reliability of the electronic component 50 by the solder 40 on the circuit board 10, while efficiently dissipating heat generated by the electronic component 50 from the heat dissipation pattern 18.

The solder 40 (cream solder) being used for bonding the electronic component 50 to the substrate 11 often contains flux, and the flux volatilizes into flux gas when the solder 40 melts. When the flux gas is not discharged to an outside of the solder 40, the flux gas remains inside the solder 40 as a void. The remaining void in the solder 40 deteriorates bondability between the electronic component 50 and the land 13, which results in heat generated by the electronic component 50 not being efficiently transferred from the solder 40 to the land 13. In contrast, in this embodiment, as described above, each of the compartment lands 21 to 24 shares at least a part of the outer edges with the outer edges of the land 13. For example, the outer edges 21a and 21d out of the outer edges 21a to 21d of the compartment land 21 are shared with the outer edges 13a and 13d of the land 13. Thus, in the compartment lands 21 to 24 partitioned by the resist 15, the outer edges shared with the outer edges of the land 13 are open outward, and therefore, flux gas in the solder 40 can be discharged outward from the outer edges (for example, the outer edges 21a and 21d) of the compartment lands 21 to 24. As a result, generation of voids in the solder 40 can be reduced, which can ensure properly maintaining bondability of the electronic component 50 by the solder 40 printed on the compartment lands 21 to 24 and transfer of heat generated by the electronic component 50 to the land 13.

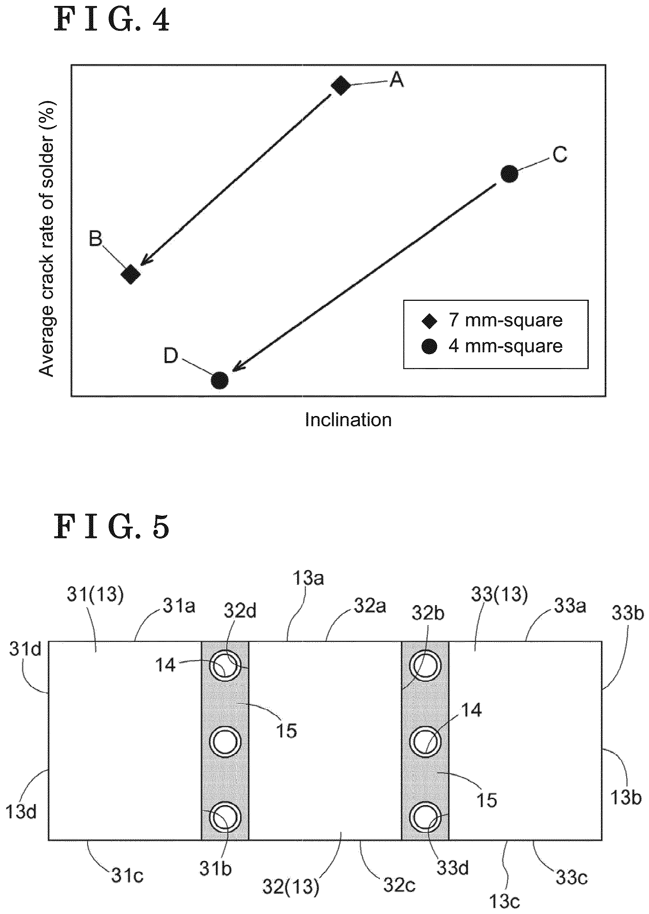

Fig. 4 is a graph illustrating an effect of the first embodiment. An inclination of an electronic component 50 and an average crack rate of solder have been measured in a case that a 7 mm-square electronic component 50 and a 4 mm-square electronic component 50 are bonded to a land 13 of a substrate 11 through solder 40 in mode 1 (comparative example) in which no resist is provided in a region surrounding the entire circumference of openings of via holes, and in mode 2 (the first embodiment) in which a cross-shaped resist 15 is provided on a land 13 in a region surrounding the entire circumference of openings 14a of via holes 14. As illustrated in Fig. 4, when the 7 mm-square electronic component 50 is bonded to the substrate 11, a significant decrease appears both in the inclination of the electronic component 50 and the average crack rate of the solder in mode 2 (point B) compared to mode 1 (point A). Further, even when the 4 mm-square electronic component 50 is bonded to the substrate 11, mode 2 (point D) expresses a significant decrease both in the inclination of the electronic component 50 and the average crack rate of the solder, compared to mode 1 (point C).

### [Second Embodiment]

In this embodiment, as illustrated in Fig. 5, a land 13 is formed in a plan view rectangle shape. The plan view rectangle shape of the land 13 allows easy soldering of a rectangular electronic component 50. The land 13 has outer edges 13a and 13c in a longitudinal direction and outer edges 13b and 13d in a short direction equivalent to the four sides. As illustrated in Fig. 5, a plurality of via holes 14 are arranged in such a way that the land 13 is evenly partitioned in the longitudinal direction. Three of the plurality of via holes 14 are provided in each of two rows from the outer edge 13b over to the outer edge 13d in the short direction of the land 13 with spacing in the longitudinal direction. The resist 15 is provided as two straight portions from the outer edge 13a over to the outer edge 13c of the land 13 while surrounding a circumference of each of two rows of the via holes 14. The two straight portions of the resist 15 divide and form three compartment lands 31 to 33 in the land 13.

The compartment land 31 located on the left end of the land 13 in Fig. 5 has outer edges 31a to 31d equivalent to the four sides. Among the outer edges 31a to 31d, the outer edges 31a, 31c, and 31d are shared with the outer edges 13a, 13c, and 13d of the land 13, respectively. The compartment land 32 located at the center of the land 13 in Fig. 5 has outer edges 32a to 32d equivalent to the four sides. Among the outer edges 32a to 32d, the outer edges 32a and 32c are shared with the outer edges 13a and 13c of the land 13, respectively. The compartment land 33 located on the right end of the land 13 in Fig. 5 has outer edges 33a to 33d equivalent to the four sides. Among the outer edges 33a to 33d, the outer edges 33a, 33b, and 33c are shared with the outer edges 13a, 13b, and 13c of the land 13, respectively.

In this embodiment, in the compartment lands 31 to 33 partitioned by the resist 15, at least a part (the outer edges 31a, 31c, and 31d) of the outer edges (for example, the outer edges 31a to 31d of the compartment land 31) are shared with the outer edges of the land 13 (any of the outer edges 13a to 13d) and are open outward. Thus, flux gas being generated when the solder 40 melts can be discharged to an outside from the outer edges of the compartment lands 31 to 33 (for example, the outer edges 31a, 31c, and 31d). As a result, generation of voids in the solder 40 can be reduced, which can ensure properly maintaining bondability of the electronic component 50 to the substrate 11 by the solder 40 printed on the compartment lands 31 to 33 and transfer of heat generated by the electronic component 50 to the land 13.

### (Other Embodiments)

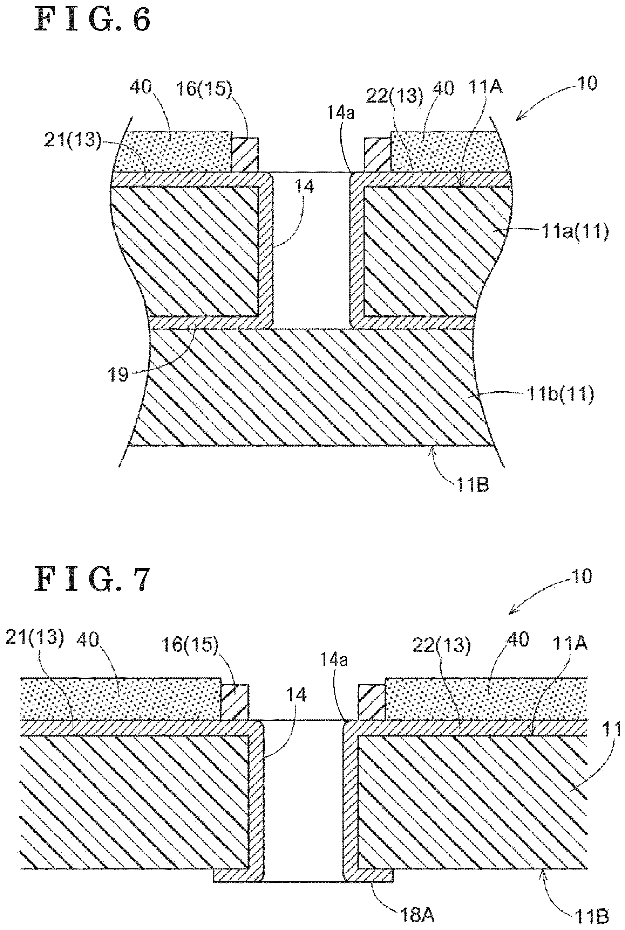

(1) The first embodiment describes an example in which the resist 15 is formed as two orthogonal straight portions (the vertical portion 16 and the horizontal portion 17). However, the resist 15 may be in a form of a plurality of straight portions intersecting with one another at an angle other than orthogonal. Further, in the plan view square-shaped land 13 of the first embodiment and in the plan view rectangular land 13 of the second embodiment, the resist 15 may have two straight portions that are formed along the diagonal lines of the land 13 that intersect with each other.
(2) The second embodiment describes an example in which the linear resists 15 are provided on the land 13 without intersecting with each other. However, the resist 15 may have a shape having a vertical portion 16 and a horizontal portion 17 that intersect with each other as in the first embodiment, on a rectangular land 13 as in the second embodiment.
(3) The first embodiment describes an example in which the circuit board 10 is a two-layer board (double-sided board) in which a copper foil pattern, which is an example of a conductive material, is arranged on each of both sides of the substrate 11. As illustrated in Fig. 6, the circuit board 10 may be a multilayer board in which a substrate 11 is constituted of two resin layers 11a and 11b and an inner layer 19 is arranged between the resin layers 11a and 11b. The inner layer 19 is formed of a conductive material and constitutes a conductive layer. The via hole 14 is formed so as to penetrate only the resin layer 11a from one side 11A of the substrate 11, and is not formed in the resin layer 11b. Therefore, in the example illustrated in Fig. 6, the land 13 and the inner layer 19 are electrically connected through the via hole 14, and the inner layer 19 serves as a heat sink.
(4) The circuit board 10 of the first embodiment describes an example in which the heat dissipation pattern 18 is provided on the other side 11B of the substrate 11 as a heat sink. However, as illustrated in Fig. 7, instead of the heat dissipation pattern, a second land 18A may be provided as a heat sink only in a region surrounding the entire circumference of the opening 14a of the via hole 14 on the other side 11B of the substrate 11.
(5) As illustrated in Fig. 8, in the circuit board 10, the substrate 11 may be constituted of three resin layers 11a, 11b and 11c, an inner layer 19a may be arranged between the resin layers 11a and 11b, and an inner layer 19b may be arranged between the resin layers 11b and 11c. In the example illustrated in Fig. 8, in the circuit board 10, the via hole 14 is a through-hole via that penetrates all of the resin layers 11a, 11b, and 11c, and the via hole 14 electrically connects the land 13, the two inner layers 19a and 19b, and the second land 18A. Thus, in this case, the two inner layers 19a and 19b and the second land 18A serve as a heat sink. In the example illustrated in Fig. 8, a heat dissipation pattern 18 may be provided instead of the second land 18A.
(6) The above-described embodiments describe examples in which the shape of the land 13 is square or rectangular. However, the shape of the land 13 is not limited to the above-described shapes and may be, for example, circular or elliptical. Further, the above-described embodiments describe an example in which the four compartment lands 21 to 24 have the same area and an example in which the three compartment lands 31 to 33 have the same area, but the plurality of compartment lands may have different areas.
(7) The above-described embodiments describe an example in which the resists 15 are formed linear and partition the land 13 into the plurality of compartment lands 21 to 24 or 31 to 33. However, the resist 15 may be provided only in a region surrounding the entire circumference of the opening 14a of the via hole 14.

This disclosure is widely applicable to circuit boards.

## Claims

1. A circuit board (10) comprising:
a substrate (11) having a plurality of layers made of a conductive material;
a land (13) being provided on a first layer being one of the layers arranged on a surface of one side of the substrate (11), to which an electronic component (50) is soldered;
a heat sink (18) being provided on another one of the layers that is arranged on the substrate (11) and is different from the first layer; and
a via hole (14) that is provided on the substrate (11) from a part of the land (13) over to a part of the heat sink (18) and is electrically connected to the land (13) and the heat sink (18), wherein
the via hole (14) has an opening formed on the land (13), and
the circuit board (10) further comprises an insulating resist (15) that is disposed on the land (13) and surrounds an entire circumference of the opening of the via hole (14).

2. The circuit board (10) according to Claim 1, wherein the land (13) includes a plurality of compartment lands partitioned by the resist (15).

3. The circuit board (10) according to Claim 2, wherein each of a plurality of the compartment lands shares at least a part of an outer edge with an entire outer edge of the land (13).
